# EUROPEAN PATENT APPLICATION

(11) **EP 4 780 192 A2**
(43) Date of publication of application: **22.07.2026**
(21) Application number: 25196702.2
(22) Date of filing: 19.08.2025
(51) Int. Cl.: H10W 20/41, H10W 20/40, H10W 72/00, H10W 90/20, H10W 90/00

(54) **PACKAGING STRUCTURE, PACKAGING METHOD, CHIP STACKING STRUCTURE AND ELECTRONIC DEVICE**

(30) Priority: 21.01.2025 CN 202510099235
(71) Applicant: Beijing X-Ring Technology Co., Ltd., Beijing 100085 (CN)
(72) Inventor: JING, Xiangmeng, Beijing, 100085 (CN); ZHANG, Xiaodong, Beijing, 100085 (CN); LIU, Haiqi, Beijing, 100085 (CN); HUANG, Yonggang, Beijing, 100085 (CN); YANG, Shengyuan, Beijing, 100085 (CN); YIN, Shengbao, Beijing, 100085 (CN)
(74) Representative: Stöckeler, Ferdinand

(57) **Abstract**

The invention relates to a packaging structure, a packaging method, a chip stacking structure and an electronic device. The packaging structure includes a first chip (1) and a second chip (2) stacked with the first chip, and the first chip has a first element (11). An active surface of the second chip is arranged opposite to an active surface of the first chip. The second chip includes a shielding element (21) arranged on one side of the second chip close to the first chip, and the shielding element is configured for reducing signal interference from the second chip to the first element. According to the packaging structure of the invention, the second chip has the shielding element, and the shielding element is arranged on the side of the second chip close to the first chip. The signal interference from the second chip to the first element may be reduced or even avoided by the usage of the shielding element, which improves a signal quality of the first element, thereby improving a signal quality of the packaging structure.

## Description

### TECHNICAL FIELD

The invention relates to the technical field of semiconductors, in particular to a packaging structure, a packaging method, a chip stacking structure and an electronic device.

### BACKGROUND

Three-dimensional stacking chips can not only realize high-density vertical interconnections between chips via hybrid bonding and other means to improve an equivalent two-dimensional integration density of chips, but also integrate a heterogeneous and heterotypic integration across different process nodes to enhance the functional density of a system, in order to meet an increasing demand for computing power. However, high-integration chip stacking may result in a smaller spacing between chips, and thus high-rate signals within different chips may interfere with each other, affecting an integrity of the high-rate signals.

### SUMMARY

According to a first aspect of the invention, a packaging structure includes: a first chip and a second chip stacked with the first chip, and the first chip has a first element. An active surface of the second chip is arranged opposite to an active surface of the first chip. The second chip includes a shielding element. The shielding element is arranged on one side of the second chip close to the first chip, and is configured for reducing signal interference from the second chip to the first element.

In an embodiment of the invention, an orthographic projection of the shielding element in a direction towards the first chip at least partially covers the first element.

In an embodiment of the invention, an area of the orthographic projection of the shielding element in the direction towards the first chip is larger than an area of a region where the first element is located.

In an embodiment of the invention, the second chip includes a first circuit, and the first circuit is arranged on one side of the shielding element away from the first element in a thickness direction of the packaging structure.

In an embodiment of the invention, the first chip includes a plurality of first wiring layers arranged along a thickness direction of the packaging structure. At least one of the first wiring layers is a first top layer, the first top later is arranged closer to the second chip than other first wiring layers in the thickness direction of the packaging structure, and the first element is at least partially arranged on the first top layer.

In an embodiment of the invention, the second chip includes a plurality of second wiring layers arranged along a thickness direction of the packaging structure. At least one of the second wiring layers is a second top layer, the second wiring layer is arranged closer to the first chip than other second wiring layers in the thickness direction of the packaging structure, and the shielding element is arranged on the second top layer.

In an embodiment of the invention, the first chip has a plurality of first electrical connectors, the second chip has a plurality of second electrical connectors, and the second electrical connectors are interconnected with the first electrical connectors respectively. An electrical connection region and a clearance region are arranged between the first chip and the second chip, the first electrical connectors and the second electrical connectors are arranged in the electrical connection region, and an orthographic projection of the clearance region in a direction towards the first element at least partially covers the first element.

In an embodiment of the invention, an area of the orthographic projection of the clearance region in the direction towards the first element is larger than an area where the first element is located.

In an embodiment of the invention, a minimum distance between an edge of the orthographic projection of the clearance region in the direction towards the first element and the first element is greater than or equal to 5µm.

In an embodiment of the invention, an orthographic projection of the first element in a direction towards the second chip is polygonal, and a shape of the clearance region is polygonal.

In an embodiment of the invention, there are a plurality of first elements and a plurality of clearance regions, and the clearance region is arranged corresponding to at least one first element.

In an embodiment of the invention, a spacing between two adjacent clearance regions is greater than or equal to 20µm.

In an embodiment of the invention, an area of the clearance region is less than or equal to 0.08mm².

In an embodiment of the invention, the shielding element includes a metal layer.

In an embodiment of the invention, a metal density of a region where the metal layer is located is 30% to 50%.

In an embodiment of the invention, the shielding element is grounded or connected to a power supply.

In an embodiment of the invention, the shielding element includes a first shielding part and a second shielding part, and both the first shielding part and the second shielding part are comb-shaped; and/or, the shielding element includes a first shielding part and a second shielding part, the first shielding part includes a plurality of first metal strips arranged side by side, and the second shielding part includes a plurality of second metal strips arranged side by side, in which the first metal strips and the second metal strips are arranged alternately in sequence.

In an embodiment of the invention, the first chip includes a logic chip and the second chip includes a memory chip, or the first chip and the second chip are both logic chips.

In an embodiment of the invention, the first element includes at least one of an inductor, a sensor or a capacitor.

According to a second aspect of the invention, a packaging method is used for forming the packaging structure described above. The packaging method includes:
providing a first chip having a first element;
providing a second chip having a shielding element; and
stacking the first chip and the second chip, in which the shielding element is arranged on one side of the second chip close to the first chip, an active surface of the second chip is arranged opposite to an active surface of the first chip, and the shielding element is configured to reduce signal interference from the second chip to the first element.

In an embodiment of the invention, providing the first chip having the first element, includes:
forming one or more first wiring layers on the active surface of the first chip, in which the first wiring layers are arranged along a thickness direction of the packaging structure; and
forming the first element via at least one of the first wiring layers.

In an embodiment of the invention, in the packaging method,
at least one of the first wiring layers is a first top layer, in which the first top later is arranged closer to the second chip than other first wiring layers in the thickness direction of the packaging structure, and the first element is at least partially arranged on the first top layer.

In an embodiment of the invention, providing the second chip having the shielding element, includes:
forming one or more second wiring layers on the active surface of the second chip, in which the second wiring layers are arranged along a thickness direction of the packaging structure; and
forming the shielding element via at least one of the second wiring layers.

In an embodiment of the invention, at least one of the second wiring layers is a second top layer, in which the second top layer is arranged closer to the first chip than other second wiring layers in the thickness direction of the packaging structure, and the shielding element is arranged on the second top layer.

In the invention, the first top layer, the second top layer or the shielding layer may be formed by related arts, such as a patterning process, which is not described in the invention.

According to a third aspect of the invention, a chip stacking structure includes a substrate and a packaging structure arranged on the substrate. The packaging structure is the packaging structure described above.

According to a fourth aspect of the invention, an electronic device includes a printed circuit board and the packaging structure according to any one of the above embodiments, and the printed circuit board is connected with the packaging structure.

According to the packaging structure of the invention, the second chip has the shielding element, and the shielding element is arranged on the side of the second chip close to the first chip. The signal interference from the second chip to the first element may be reduced or even avoided by the usage of the shielding element, which improves a signal quality of the first element, thereby improving a signal quality of the packaging structure.

### BRIEF DESCRIPTION OF THE DRAWINGS

FIG. 1 is a cross-sectional view of a packaging structure according to an embodiment of the invention.
FIG. 2 is a local cross-sectional view of a packaging structure according to an embodiment of the invention.
FIG. 3 is a cross-sectional view of a packaging structure according to another embodiment of the invention.
FIG. 4 is an enlarged view of part A in FIG. 3.
FIG. 5 is a schematic diagram of a shielding element of a packaging structure according to another embodiment of the invention.
FIG. 6 is a schematic diagram of a shielding element and a first element of a packaging structure according to another embodiment of the invention.
FIG. 7 is a schematic diagram of a shielding element of a packaging structure according to further another embodiment of the invention.
FIG. 8 is a schematic diagram of a shielding element of a packaging structure according to yet another embodiment of the invention.
FIG. 9 is a schematic diagram of a shielding element of a packaging structure according to yet another embodiment of the invention.
FIG. 10 is a schematic diagram of an electrical connection region and a clearance region of a packaging structure according to yet another embodiment of the invention.
FIG. 11 is a schematic diagram of an electrical connection region, a clearance region and a first element of a packaging structure according to yet another embodiment of the invention.
FIGS. 12 and 13 are simulation diagrams provided by yet another embodiment of the invention.

### DETAILED DESCRIPTION

The embodiments of the invention will be described in detail below, examples of which are illustrated in the accompanying drawings. The embodiments described below by referring to the accompanying drawings are exemplary and are intended to explain the invention, and should not be construed as limiting the invention.

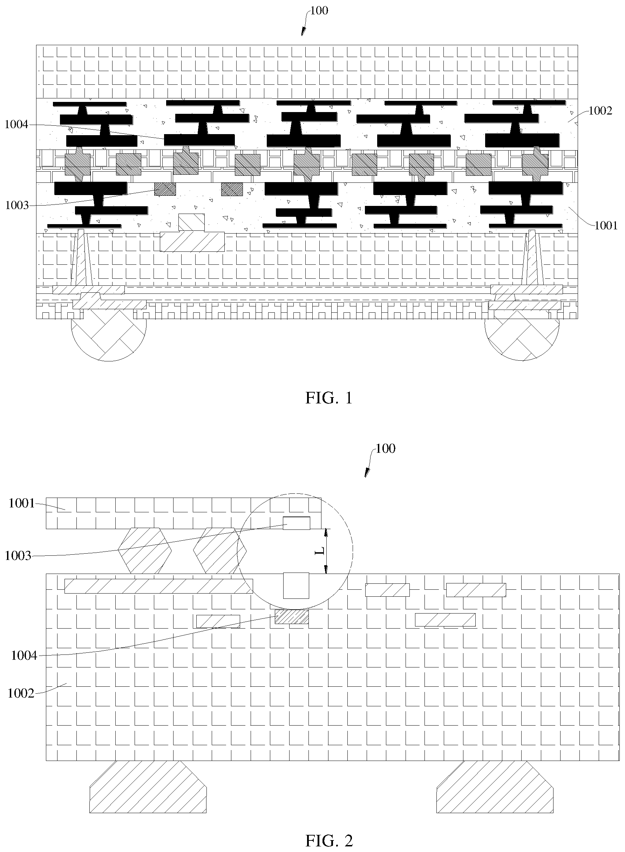

FIG. 1 and FIG. 2 illustrate a packaging structure 100 disclosed by an embodiment of the invention. In the examples of FIG. 1 and FIG. 2, the inductor element 1003 needs to be provided with a clearance region of a certain size to prevent other wires from affecting a Q value and an inductance value of the inductor element 1003. Because an active surface of a first chip 1001 and an active surface of a second chip 1002 in the packaging structure 100 are connected by means of hybrid bonding, a spacing L between the first chip 1001 and the second chip 1002 is only a few microns. The inductor element 1003 of the first chip 1001 cannot have a clearance region that meets requirements. A circuit 1004 on the second chip 1002 may interfere with the inductor element 1003 of the first chip 1001, which may reduce a signal quality of the inductor element 1003 and further affects operations of the first chip 1001. Especially in high-rate scenarios, when a transmission speed reaches 10BPS or higher, the inductor element 1003 is more susceptible to the influence of the second chip 1002. Therefore, how to improve the signal quality of the inductor element 1003 in the first chip 1001 is a technical problem to be solved urgently.

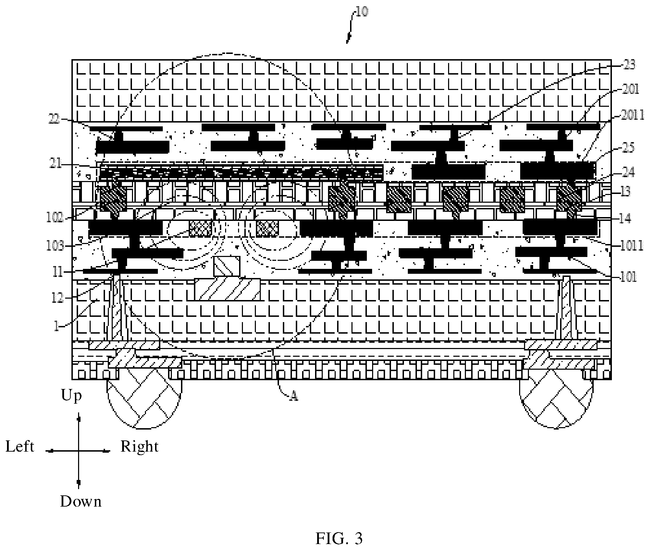

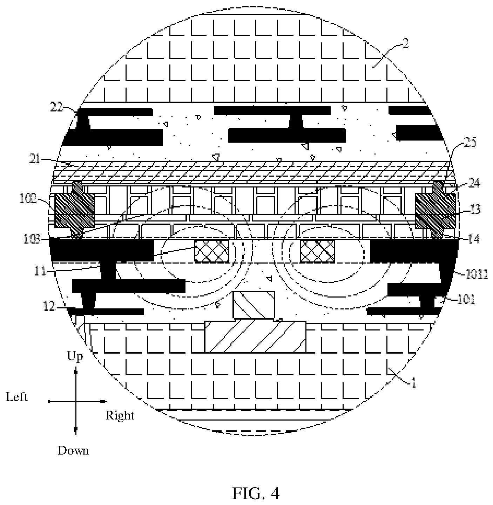

As illustrated in FIG. 3 and FIG. 4, a packaging structure 10 of an embodiment of the invention includes a first chip 1 and a second chip 2. The second chip 2 is stacked with the first chip 1, and an active surface of the second chip 2 is arranged opposite to an active surface of the first chip 1. The first chip 1 includes a first element 11, and the second chip 2 includes a shielding element 21. The shielding element 21 is arranged on one side of the second chip 2 close to the first chip 1, and is configured to reduce signal interference from the second chip 2 to the first element 11.

The shielding element 21 is arranged on one side of the second chip 2 close to the first chip 1, i.e., the second chip 2 has a first side facing the first chip 1 and a second side facing away from the first chip 1, and the shielding element 21 is arranged on the first side.

It should be noted that the chip in embodiments of the invention may be a die (also referred to as particle or bare chip) or a chip wafer. It may be understood that after an epitaxial layer is grown on a wafer, the chip wafer is formed, and a bare chip (die) is obtained by cutting the chip wafer. Die-to-die (D2D) bonding may be performed between dies. Chip wafer bonding is referred to as wafer-to-wafer (W2W) bonding. A structure where a plurality of dies are stacked on the wafer may be referred to as die-to-wafer (D2W) bonding. The packaging in the invention may also be at least one of a chip-to-Wafer (C2W) bonding, a die-to-wafer (D2C) bonding and a chip-to-chip (C2C) bonding.

A number of chips stacked in a chip stacking structure is not limited by the invention, and may be set according to application requirements. In addition, the above chip may be a memory chip, a logic chip or other functional chips.

In the packaging structure 10 of embodiments of the invention, the second chip 2 has the shielding element 21, and the shielding element 21 is arranged on the side of the second chip 2 close to the first chip 1. The signal interference from the second chip 2 to the first element 11 may be reduced or even avoided by the usage of the shielding element 21, which improves a signal quality of the first element 11, thereby improving a signal quality of the packaging structure 10.

In an embodiment of the invention, the first chip 1 includes a logic chip and the second chip2 includes a storage chip. Alternatively, the first chip 1 and the second chip 2 are both logic chips.

The logic chip may be an application chip, and the memory chip may be a dynamic random memory (DRAM) chip.

The first element of the invention include an element for realizing a specific function, which may be refer to as a functional element.

In an embodiment of the invention, the first element 11 includes an inductor. It may be understood that the first element may be other functional components under the influence of the second chip, such as a sensor, a capacitor, etc.

In the invention, the inductor element is highly susceptible to the influence of the second chip 2, and the solution of the invention may be applicable to scenarios where the first element 11 is an inductor.

By arranging the shielding element 21, the signal interference from the second chip 2 to the inductor, the sensor or the capacitor may be reduced or even avoided, thereby improving the signal quality of the packaging structure 10.

In order to facilitate understanding the technical solution of the invention, the technical solution of the invention will be further described by taking a thickness direction of the packaging structure 10 being consistent with an up-down direction as an example. The up-down direction is as shown in FIGS. 3 and 4.

For example, the first chip 1 is arranged on a lower side of the second chip 2, the first element 11 is arranged on a lower side of the shielding element 21, and the shielding element 21 is arranged on a lower side of the second chip 2.

In an embodiment of the invention, the second chip 2 includes a first circuit, and the first circuit 22 is arranged on one side of the shielding element 21 away from the first element 11 in the thickness direction of the packaging structure 10.

For example, the first element 11 is arranged on the lower side of the shielding element 21, and the first circuit 22 is arranged on an upper side of the shielding element 21.

By arranging the first circuit 22 on the side of the shielding element 21 away from the first element 11, the shielding element 21 is enabled to provide signal shielding for the first element 11, so as to reduce or even avoid the signal interference from the first circuit 22 to the first element 11, thereby improving the signal quality of the packaging structure 10.

In an embodiment of the invention, as illustrated in FIGS. 3 and 4, the first chip 1 includes a plurality of first wiring layers 101 arranged along the thickness direction of the packaging structure 10. At least one of the first wiring layers 101 is a first top layer 1011, and the first top layer 1011 is arranged closer to the second chip 2 than other first wiring layers 101 in the thickness direction of the packaging structure 10. The first element 11 is at least partially arranged on the first top layer 1011.

The first element 11 is at least partially arranged on the first top layer 1011, i.e., a part of the first element 11 is arranged on the first top layer 1011, and the remaining part of the first element 11 is arranged on other first wiring layers 101; or, the entire first element 11 is arranged on the first top layer 1011.

For example, a plurality of first wiring layers 101 are arranged in the up-down direction. One of the first wiring layers 101 is the first top layer 1011, and the first top layer 1011 among the plurality of first wiring layers 101 is located on the uppermost side.

In embodiments of the invention, among the plurality of first wiring layers 101, the closer the first wiring layer 101 is to the second chip 2, the greater its thickness and the smaller its resistance.

By arranging at least a part of the first element 11 on the first top layer 1011, a parasitic resistance of the first element 11 may be reduced, thereby improving the Q value of the first element 11, further improving the signal quality of the first element 11, and improving the signal quality of the packaging structure 10.

In an embodiment of the invention, as illustrated in FIG. 3, the first chip 1 further includes a second circuit 12 arranged on at least one side of the first element 11 in a preset direction, in which the preset direction is perpendicular to the thickness direction of the packaging structure 10.

In order to facilitate understanding the technical solution of the invention, the technical solution of the invention will be further described by taking the preset direction as a left-right direction as an example. The left-right direction is as shown in FIGS. 3 and 4.

For example, the second circuit 12 is located on left and right sides of the first element 11 in the left-right direction.

Compared with arranging the second circuit 12 on the side of the first element 11 away from the shielding element 21 in the preset direction, arranging the second circuit 12 on at least one side of the first element 11 in the preset direction may reduce an interference from the second circuit 12 to the first element 11, which further improves the signal quality of the first element 11, and improving the signal quality of the packaging structure 10.

In an embodiment of the invention, as illustrated in FIG. 3, the second chip 2 includes a plurality of second wiring layers 201 arranged along the thickness direction of the packaging structure 10. At least one of the second wiring layers 201 is a second top layer 2011, and the second top layer 2011 is arranged closer to the first chip 1 than other second wiring layers 201 in the thickness direction of the packaging structure 10. The shielding element 21 is arranged on the second top layer 2011.

For example, the plurality of second wiring layers 201 are arranged in the up-down direction. One of the second wiring layers 201 is the second top layer 2011. The second top layer 2011 among the plurality of the second wiring layers 201 is located on the uppermost side.

It is understood that among the plurality of second wiring layers 201, the closer the second wiring layer 201 is to the first chip 1, the greater of a thickness of the second wiring layer 201.

By arranging the shielding element 21 on the second top layer 2011, on the one hand, a signal shielding effect of the shielding element 21 may be enhanced, thereby further improving the signal quality of the first element 11, and improving the signal quality of the packaging structure 10; on the other hand, the remaining second wiring layers 201 far away from the first element 11 may be used as the first circuit 22, which improves an integration of the second chip 2, thus improving an integration of the packaging structure 10.

In an embodiment of the invention, as illustrated in FIG. 3, the second chip 2 further includes a third circuit 23 arranged on at least one side of the shielding element 21 in the preset direction, in which the preset direction is perpendicular to the thickness direction of the packaging structure 10.

For example, the third circuit 23 is located on left and right sides of the shielding element 21 in the left-right direction.

By arranging the third circuit 23 on at least one side of the shielding element 21 in the preset direction, the integration of the second chip 2 may be further improved, thereby improving the integration of the packaging structure 10.

In an embodiment of the invention, as illustrated in FIGS. 3 and 4, the first chip 1 has a plurality of first electrical connectors 13, and the second chip 2 has a plurality of second electrical connectors 24. The second electrical connectors are interconnected with the first electrical connectors respectively. The first chip 1 includes the first wiring layer 101, and the shielding element 21 is electrically connected with the first wiring layer 101 via the second electrical connector 24 and the first electrical connector 13.

As illustrated in FIG. 3, the first chip 1 has a first through hole 14, and the first electrical connector 13 passes through the first through hole 14 to reach a circuit of the first chip 1. The second chip 2 has a second through hole 25, and the second electrical connector 24 passes through the second through hole 25 to reach a circuit of the second chip 2. That is, the first chip 1 and the second chip 2 are connected by means of hybrid bonding.

The shielding element 21 is electrically connected with the first wiring layer 101 via the second electrical connector 24 and the first electrical connector 13.

In an embodiment of the invention, the shielding element 21 includes a shielding layer made of electromagnetic shielding material.

In an embodiment of the invention, the shielding element 21 includes a metal layer.

It is understood that the shielding element 21 in the invention is not limited to a metal layer or an electromagnetic shielding layer, but also other elements with an electromagnetic shielding function.

By configuring the shielding element 21 to include the metal layer, a signal shielding effect of the shielding element 21 may be enhanced, which further improves the signal quality of the first element 11 and improves the signal quality of the packaging structure 10.

In an embodiment of the invention, a metal density of a region where the metal layer is located is 30% to 50%.

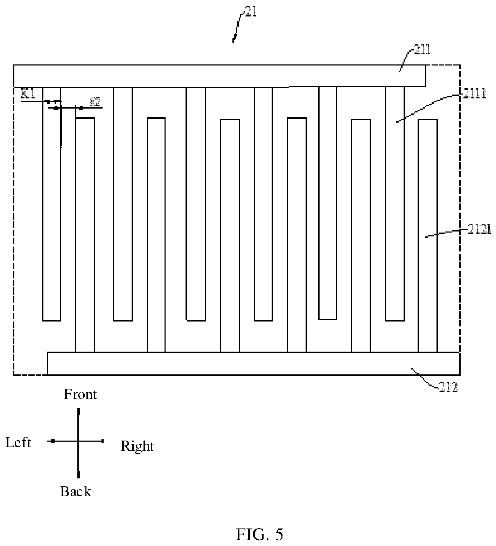

For example, as illustrated in FIG. 5, a region within a dashed frame is the region where the metal layer is located, and a ratio of an area of the metal layer to an area of the dashed frame is a metal density of the region where the metal layer is located.

By setting the metal density of the region where the metal layer is located to 30% to 50%, an amount of metal in the shielding element 21 may be reduced while ensuring the shielding effect of the shielding element 21, so as to reduce a cost of the packaging structure 10. In an embodiment of the invention, the shielding element 21 is grounded or connected to a power supply.

For example, the shielding element 21 is electrically connected with the first wiring layer 101, and the first wiring layer 101 is grounded or connected to a power supply, thereby enabling the shielding element 21 to be grounded or connected to the power supply.

By grounding the shielding element 21, the signal shielding effect of the shielding element 21 may be improved, and the signal interference from the second chip 2 to the first element 11 may be reduces, thus further improving the signal quality of the packaging structure 10.

In an embodiment of the invention, as illustrated in FIGS. 5-7, the shielding element 21 includes at least one shielding part 213, and the shielding part 213 is comb-shaped.

For example, as illustrated in FIGS. 5-6, the shielding element 21 includes two shielding parts 213, both of the two shielding parts 213 are comb-shaped.

By configuring the shielding part 213 of the shielding element 21 into a comb shape, the signal shielding effect of the shielding element 21 may be effectively improved, which reduces the signal interference to the first element 11, and further improves the signal quality of the packaging structure 10.

In an embodiment of the invention, as illustrated in FIGS. 5-6, the shielding element 21 includes a plurality of shielding parts 213. At least one of the shielding parts 213 is a first shielding part 211, and at least one of the shielding parts 213 is a second shielding part 212. The first shielding part 211 includes a plurality of first metal strips 2111 arranged side by side, and the second shielding part includes a plurality of second metal strips 2121 arranged side by side. The first metal strips and the second metal strips are arranged alternately at intervals in sequence.

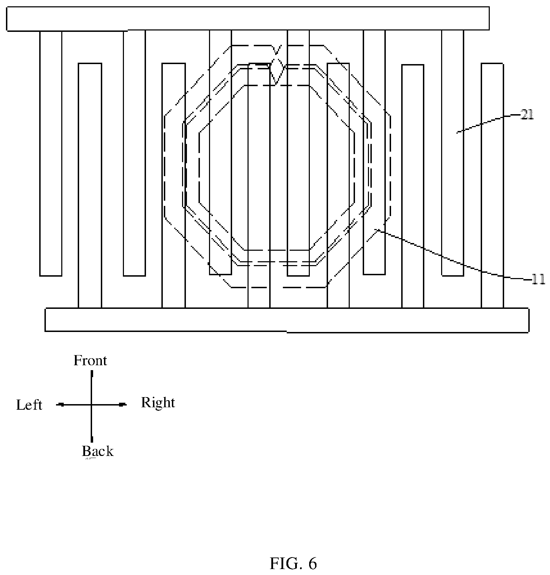

For example, as illustrated in FIGS. 5-6, the first shielding part 211 is arranged in a front side of the second shielding part 212, and the plurality of first metal strips 2111 and the plurality of second metal strips 2121 are arranged alternately at intervals along the left-right direction. The front-back direction and the left-right direction are shown in FIGS. 5 and 6.

By configuring the shielding element 21 to the above structure, the signal shielding effect of the shielding element 21 may be effectively improved, the signal interference to the first element 11 may be reduced, further improving the signal quality of the first element 11 and improving the signal quality of the packaging structure 10.

In an embodiment of the invention, as illustrated in FIGS. 5-6, a width of the first metal strip 2111 is 0.4µm to 12.5µm. A width of the second metal strip 2121 is 0.4µm-12.5µm

For example, as illustrated in FIG. 5, the width of both the first metal strip 2111 and the second metal strip 2121 is K1, where K1 is 1.8µm.

By setting the width of the first metal strip 2111 and the second metal strip 2121 to 0.4µm to 12.5µm, it is convenient for manufacturing the shielding element 21, which thus facilitates manufacturing of the packaging structure 10, thereby reducing the cost of the packaging structure 10.

In an embodiment of the invention, as illustrated in FIGS. 5-6, a spacing between the first metal strip 2111 and the adjacent second metal strip 2121 is 0.4µm to 25µm.

For example, as illustrated in FIG. 5, the spacing between the first metal strip 2111 and the second metal strip 2121 is K2, where K2 is 2.7µm.

By setting the spacing between the first metal strip 2111 and the second metal strip 2121 to 0.4µm to 25µm, it is convenient for manufacturing the shielding element 21, which thus facilitates manufacturing of the packaging structure 10, thereby reducing the cost of the packaging structure 10.

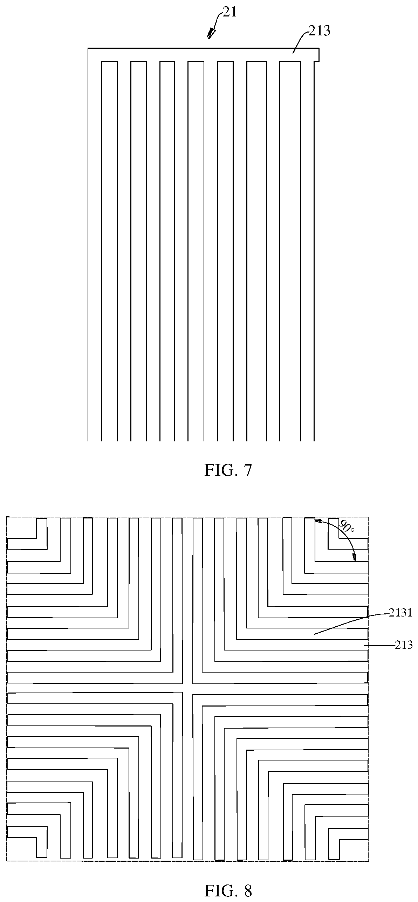

In an embodiment of the invention, as illustrated in FIG. 8, the shielding element 21 includes a plurality of shielding parts 213, and the plurality of shielding parts 213 are uniformly arranged along a circumferential direction of a preset rectangular frame. The shielding part 213 include a plurality of V-shaped metal strips 2131. The plurality of metal strips 2131 of the same shielding part 213 are arranged at intervals along an inward-outward direction, and a length of the metal strip 2131 located on an outer side is smaller than a length of the metal strip 2131 located on an inner side. A dashed frame in FIG. 8 is the preset rectangular frame.

Herein, "inward" may be understood as: a direction approaching a center of the rectangular frame in a plane where the shielding element 21 is located; "outward" may be understood as: a direction away from the center of the rectangular frame in the plane where the shielding element 21 is located.

By configuring the shielding element 21 to the above structure, the signal shielding effect of the shielding element 21 may be improved effectively, which reduces the signal interference to the first element 11 and improves the signal quality of the first element 11, thus improving the signal quality of the packaging structure 10.

In an embodiment of the invention, as illustrated in FIG. 8, there are four shielding parts 213, and an included angle of the metal strip 2131 is 90°.

By configuring four shielding parts 213 and configuring the inner included angle of the metal strip 2131 to 90°, it is convenient to manufacture the shielding element 21, which facilitates manufacturing of the packaging structure 10, thus reducing the cost of the packaging structure 10.

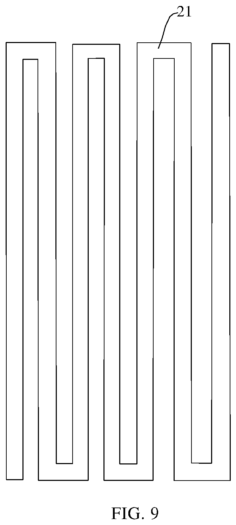

In an embodiment of the invention, as illustrated in FIG. 9, the shielding element 21 is in a shape of a rectangular pulse signal waveform.

By configuring the shielding element 21 to the above structure, the signal shielding effect of the shielding element 21 is effectively improved, which reduces the signal interference to the first element 11 and improves the signal quality of the first element 11, thus improving the signal quality of the packaging structure 10. In addition, configuring the shielding element 21 into the shape of the rectangular pulse signal waveform may facilitate the manufacturing of the shielding element 21, which thus facilitates the manufacturing of the packaging structure 10, thereby reducing the cost of the packaging structure 10.

In an embodiment of the invention, as illustrated in FIG. 6, an orthographic projection of the shielding element 21 in a direction towards the first chip 1 at least partially covers the first element 11.

The statement that "he orthographic projection of the shielding element 21 in the direction towards the first chip 1 at least partially covers the first element 11" may be understood as: the orthographic projection of the shielding element 21 in the direction towards the first chip 1 entirely covers the first element 11; or, a part of the orthographic projection of the shielding element 21 in the direction toward the first chip 1 covers the first element 11, and the remaining orthographic projection of the shielding element 21 in the direction toward the first chip 1 does not cover the first element 11.

By configuring the orthographic projection of the shielding element 21 in the direction toward the first chip 1 to at least partially cover the first element 11, the signal shielding effect of the shielding element 21 may be improved, which further improves the signal quality of the first element 11, and improves the signal quality of the packaging structure 10.

In an embodiment of the invention, as illustrated in FIG. 6, an area of the orthographic projection of the shielding element 21 in the direction toward the first chip 1 is larger than an area of a region where the first element 11 is located. That is, the orthographic projection of the shielding element 21 in the direction toward the first chip 1 not only covers the first element 11, but also covers an edge of the first element 11, so as to cover more signals generated by the first element 11.

By setting the area of the orthographic projection of the shielding element 21 in the direction toward the first chip 1 to be larger than the area of the region where the first element 11 is located, the signal shielding effect of the shielding element 21 may be further improved, which further improves the signal quality of the first element 11, and improves the signal quality of the packaging structure 10.

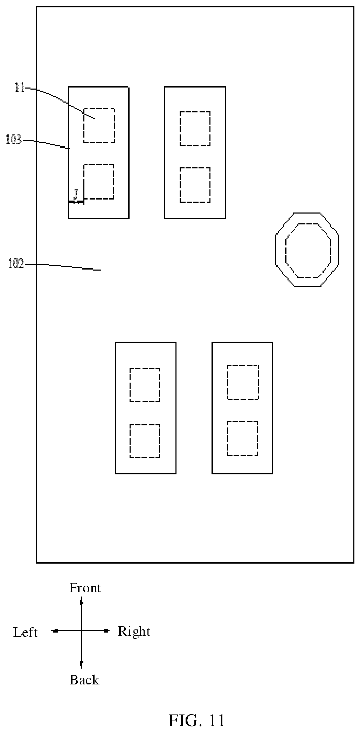

In an embodiment of the invention, as illustrated in FIGS. 3 and 11, an electrical connection region 102 and a clearance region 103 are arranged between the first chip 1 and the second chip 2. The first electrical connectors 13 and the second electrical connectors 24 are arranged in the electrical connection region 102, and an orthographic projection of the clearance region 103 in a direction towards the first element 11 covers the first element 11.

It is understood that both the first electrical connector 13 and the second electrical connector 24 are conductive parts that may also cause interference to the first element 11.

By setting the orthographic projection of the clearance region 103 in the direction towards the first element 11 to cover the first element 11, the orthographic projections of the first electrical connector 13 and the second electrical connector 24 in the direction towards the first element 11 thus does not cover the first element 11, so that the interference from the first electrical connector 13 and the second electrical connector 24 to the first element 11 may be reduced, which further improves the signal quality of the first element 11, and improves the signal quality of the packaging structure 10.

In an embodiment of the invention, a minimum distance between an edge of the orthographic projection of the clearance region in the direction towards the first element 11 and the first element 11 is greater than or equal to 5µm.

In the invention, the minimum distance between the edge of the orthographic projection of the clearance region 103 in the direction towards the first element 11 and the first element 11 means a shortest straight-line distance between the orthographic projections of the clearance region 103 and the first element 11 on the plane where the first element 11 is located. As illustrated in FIG. 11, the shortest distance J between the first element 11 and the clearance region 103 is 5µm.

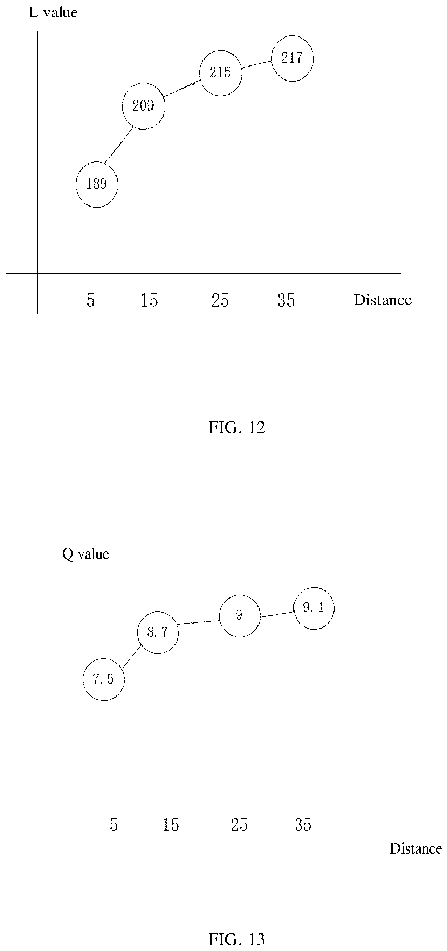

Taking the first element 11 being an inductor element as an example, the distance between the edge of the orthographic projection of the clearance region 103 on the first element 11 and the first element 11 will affect an inductance value (L value) and Q value of the inductor element. As illustrated in FIG. 12, the horizontal coordinate represents the minimum distance between the edge of the orthographic projection of the clearance region 103 on the first element 11 and the first element 11, and the vertical coordinate represents the inductance value (L value) of the inductor element. As illustrated in FIG. 13, the horizontal coordinate represents the shortest straight-line distance between the orthographic projections of the clearance region 103 and the first element 11 on the plane where the first element 11 is located, and the vertical coordinate represents the Q value of the inductor element. It may be seen that when the minimum distance between the edge of the orthographic projection of the clearance region 103 on the first element 11 and the first element 11 is greater than 5µm, the signal from the second chip 2 may be well reduced, and the performance of the first element 11 may be ensured.

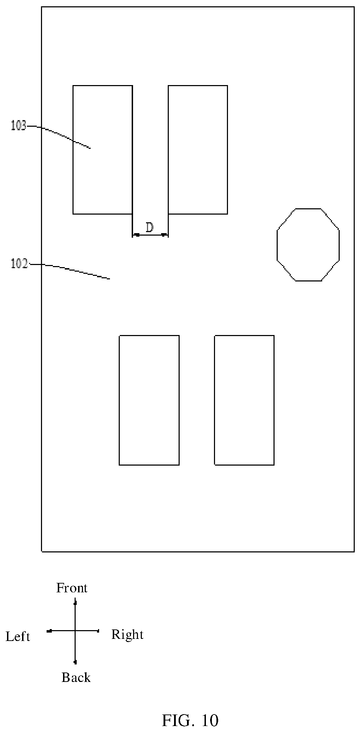

In an embodiment of the invention, as illustrated in FIG. 10 and FIG. 11, there are a plurality of first elements 11 and a plurality of clearance regions 103, and the clearance region 103 is arranged corresponding to at least one first element 11.

For example, as illustrated in FIG. 11, there are nine first elements 11 and five clearance regions 103. Some of the clearance regions 103 are arranged corresponding to two first elements 11, and some of the clearance regions 103 are arranged corresponding to one first element 11.

By providing the plurality of first elements 11 and the plurality of clearance regions 103, the plurality of the first elements 11 may be integrated on the same first chip 1, to improve the integration of the packaging structure 10.

In an embodiment of the invention, as illustrated in FIG. 10, an orthographic projection of the first element 11 in a direction toward the second chip 2 is polygonal, and a shape of the clearance region 103 is also polygonal.

For example, as illustrated in FIG. 11, when the orthographic projection of the first element 11 in the direction toward the second chip 2 is rectangular, the shape of the corresponding clearance region 103 is also rectangular. When the orthographic projection of the first element 11 in the direction toward the second chip 2 is octagonal, the shape of the corresponding clearance region 103 is also octagonal.

It is understood that no first electrical connector 13 or second electrical connector 24 are arranged in the clearance region 103, so that in the clearance region 103, the first chip 1 and the second chip 2 cannot be connected via the first electrical connector 13 and the second electrical connector 24, which reduces a connection area between the first chip 1 and the second chip 2, and reduces a connection stability between the first chip 1 and the second chip 2.

By configuring both the orthographic projection of the first element 11 in the direction towards the second chip 2 and the shape of the clearance region 103 as polygonal, the orthographic projection may cover the corresponding first element 11 even when the area of the clearance region 103 is small, thereby improving the connection stability between the first chip 1 and the second chip 2, and improving a reliability of the packaging structure 10.

In an embodiment of the invention, as illustrated in FIG. 11, an area of the orthographic projection of the clearance region 103 in the direction towards the first element 11 is larger than an area of a region where the first element 11 is located.

By setting the area of the orthographic projection of the clearance region 103 in the direction towards the first element 11 to be larger than the area of the region where the first element 11 is located, the signal shielding effect of the shielding element 21 may be improved, and the signal quality of the first element 11 may be further improved, thus improving the signal quality of the packaging structure 10.

In an embodiment of the invention, as illustrated in FIG. 10, a distance D between two adjacent clearance regions 103 is greater than or equal to 20µm.

As mentioned above, neither first electrical connector 13 nor second electrical connector 24 is located in the clearance region 103, so that the connection area between the first chip 1 and the second chip 2 in the clearance region 103 is reduced, thus reducing the connection stability between the first chip 1 and the second chip 2.

By setting the distance between two adjacent clearance regions 103 to be greater than or equal to 20µm, e.g., 100µm, it is possible to avoid an excessive density of the clearance regions 103, which may affect the connection stability between the first chip 1 and the second chip 2, thereby improving the reliability of the packaging structure 10.

In an embodiment of the invention, an area of the clearance region 103 is less than or equal to 0.08mm². The area of the clearance region 103 may be 0.0625mm². When the clearance region 103 is smaller than the value described in an embodiment of the invention, the connection stability between the first chip 1 and the second chip 2 may be better ensured.

As mentioned above, no first electrical connector 13 or second electrical connector 24 are arranged in the clearance region 103, so that the first chip 1 and the second chip 2 cannot be connected by means of hybrid bonding in the clearance region 103, which affects the connection stability between the first chip 1 and the second chip 2.

By setting the area of the clearance region 103 to be less than or equal to 0.08mm², an area of a region where the first chip 1 and the second chip 2 are not connected with each other may be reduced, which improves the connection stability between the first chip 1 and the second chip 2, thereby improving the reliability of the packaging structure 10.

According to the packaging structure 10 of embodiments of the invention, the first element 11 is arranged on the first chip 1, and the shielding element 21 is arranged on the second chip 2. The first circuit 22 of the second chip 2 is arranged on the side of the shielding element 21 away from the first element 11, so as to reduce the signal interference from the first circuit 22 of the second chip 2 to the first element 11 and reduce the interference from the first element 11 to the first circuit 22, which improves the signal quality of the first element 11, thereby improving the signal quality of the packaging structure 10.

A packaging method of an embodiment of the invention is used to form the packaging structure 10 described in any of the above embodiments.

The packaging method of an embodiment of the invention includes:
providing the first chip 1 having the first element 11;
providing the second chip 2 having the shielding element 21; and
stacking the first chip 1 and the second chip 2, in which the shielding element 21 is arranged on one side of the second chip 2 close to the first chip 1, the active surface of the second chip 2 is arranged opposite to the active surface of the first chip 1, and the shielding element 21 is configured to reduce signal interference from the second chip 2 to the first element 11.

In some embodiments, providing the first chip 1 having the first element 11, includes:
forming one or more first wiring layers 101 on the active surface of the first chip 1, in which the first wiring layers 101 are arranged along the thickness direction of the packaging structure 10; and
forming the first element 11 via at least one of the first wiring layers 101.

A chip stacking structure according to an embodiment of the invention includes: a substrate and a packaging structure 10 arranged on the substrate, and the packaging structure 10 is the packaging structure 10 according to any of the above embodiments.

In some embodiments, in the packaging method,
at least one of the first wiring layers 101 is the first top layer 1011, in which the first top layer 1011 is arranged closer to the second chip 2 than other first wiring layers in the thickness direction of the packaging structure 10, and the first element 11 is at least partially arranged on the first top layer 1011.

In some embodiments, providing the second chip 2 having the shielding element 21, includes:
forming one or more second wiring layers 201 on the active surface of the second chip 2, in which the second wiring layers 201 are arranged along the thickness direction of the packaging structure 10; and
forming the shielding element 21 via at least one of the second wiring layers 201.

In some embodiments, at least one of the second wiring layers 201 is the second top layer 2011, in which the second top layer 2011 is arranged closer to the first chip 1 than other second wiring layers 201 in the thickness direction of the packaging structure 10, and the shielding element 21 is arranged on the second top layer 2011.

The chip stacking structure according to embodiments of the invention includes: the substrate and the packaging structure 10 arranged on the substrate, and the packaging structure is the packaging structure 10 described in any of the above embodiments.

An electronic device according to embodiments of the invention includes a printed circuit board and the packaging structure 10. The packaging structure 10 is the packaging structure 10 described in any of the above embodiments, and the printed circuit board is connected with the packaging structure 10. Herein, it is to be understood that, orientations and positional relationships indicated by terms such as "center", "longitudinal", "lateral", "length", "width", "thickness", "up", "down", "front", "back", "left", "right", "vertical", "horizontal", "top", "bottom", "in", "out", "clockwise", "counterclockwise", "axial", "radial" and "circumference" are orientations and positional relationships shown based on the accompany drawings, which are only for the convenience of describing the invention and simplifying the description, and do not indicate or imply that the referred devices or elements must have a specific orientation, or be constructed or operated in a specific orientation, so it cannot be understood as limiting the invention.

In addition, terms such as "first" and "second" are used herein for purposes of description and are not intended to indicate or imply relative importance or implicitly specify the number of technical features indicated. Furthermore, the feature defined as "first" or "second" may expressly or implicitly include at least one of those features. Herein, "a plurality of' means at least two, such as two or three, unless specified otherwise.

In the invention, unless specified or limited otherwise, the terms "mounted", "connected", "coupled" and "fixed" are understood broadly, such as fixed, detachable couplings or integrated, and can be mechanical or electrical couplings, and also can be direct and via media indirect couplings, and further can be inner couplings of two components or interaction relations between two components, which can be understood by those skilled in the art according to specific situations.

In the invention, unless otherwise expressly specified and limited, a first feature "above" or "below" a second feature means that the first feature and the second feature are in direct contact, or the first feature and the second feature are in indirect contact through an intermediate medium. Moreover, the first feature is "above", "over" and "on top of' the second feature means that the first feature is directly above or diagonally above the second feature, or simply indicates that the first feature is horizontally higher above the second feature. The first feature is "below", "under", and "beneath" the second feature means that the first feature is directly below or diagonally below the second feature, or simply indicates that the horizontal height of the first feature is lower than that of the second feature.

In the invention, the terms "an embodiment", "some embodiments", "examples", "specific examples" or "some examples" etc. mean that a specific feature, structure, material or characteristic described in combination with an embodiment or example is included in at least one embodiment or example of the invention. In the specification, the schematic expressions of the above terms are not necessarily aimed at the same embodiment or example. Moreover, the specific features, structures, materials or characteristics described may be combined in any one or more embodiments or examples in a suitable manner. In addition, those skilled in the art can combine and integrate different embodiments or examples and features of different embodiments or examples described in the specification without conflict.

Although embodiments of the invention have been shown and described above, it is understood that the above embodiments are exemplary and cannot be understood as limitations of the invention, and changes, modifications, substitutions and variations made to the above embodiments by those skilled in the art are within the protection scope of the invention.

## Claims

1. A packaging structure, comprising:
a first chip comprising a first element; and
a second chip stacked with the first chip, wherein an active surface of the second chip is arranged opposite to an active surface of the first chip;
wherein the second chip comprises a shielding element arranged on one side of the second chip close to the first chip, and the shielding element is configured to reduce signal interference from the second chip to the first element.

2. The packaging structure of claim 1, wherein an orthographic projection of the shielding element in a direction towards the first chip at least partially covers the first element.
optionally, wherein an area of the orthographic projection of the shielding element in the direction towards the first chip is larger than an area of a region where the first element is located.

3. The packaging structure of claim 1, wherein the second chip comprises a first circuit, and the first circuit is arranged on one side of the shielding element away from the first element in a thickness direction of the packaging structure.

4. The packaging structure of claim 1, wherein the first chip comprises a plurality of first wiring layers arranged along a thickness direction of the packaging structure, wherein at least one of the first wiring layers is a first top layer, the first top later is arranged closer to the second chip than other first wiring layers in the thickness direction of the packaging structure, and the first element is at least partially arranged on the first top layer; or
wherein the second chip comprises a plurality of second wiring layers arranged along a thickness direction of the packaging structure, wherein at least one of the second wiring layers is a second top layer, the second wiring layer is arranged closer to the first chip than other second wiring layers in the thickness direction of the packaging structure, and the shielding element is arranged on the second top layer.

5. The packaging structure of claim 1, wherein the first chip has a plurality of first electrical connectors, the second chip has a plurality of second electrical connectors, and the second electrical connectors are interconnected with the first electrical connectors respectively;
wherein an electrical connection region and a clearance region are arranged between the first chip and the second chip, the first electrical connectors and the second electrical connectors are arranged in the electrical connection region, and an orthographic projection of the clearance region in a direction towards the first element at least partially covers the first element.

6. The packaging structure of claim 5, wherein an area of the orthographic projection of the clearance region in the direction towards the first element is larger than an area of an orthographic projection of the first element in a direction towards the clearance region;
optionally, wherein a minimum distance between an edge of the orthographic projection of the clearance region in the direction towards the first element and an edge of the first element is greater than or equal to 5µm.

7. The packaging structure of claim 5, wherein an orthographic projection of the first element in a direction towards the second chip is polygonal, and a shape of the clearance region is polygonal; or
wherein an area of the clearance region is less than or equal to 0.08mm².

8. The packaging structure of claim 5, wherein there are a plurality of first elements and a plurality of clearance regions, and the clearance region is arranged corresponding to at least one first element;
optionally, wherein a spacing between two adjacent clearance regions is greater than or equal to 20µm.

9. The packaging structure of any one of claims 1-8, wherein the shielding element comprises a metal layer.
optionally, wherein a metal density of a region where the metal layer is located is 30% to 50%.
optionally, wherein the shielding element is grounded or connected to a power supply.

10. The packaging structure of claim 9, wherein the shielding element comprises a first shielding part and a second shielding part, and both the first shielding part and the second shielding part are comb-shaped; and/or,
wherein the shielding element comprises a first shielding part and a second shielding part, the first shielding part comprises a plurality of first metal strips arranged side by side, and the second shielding part comprises a plurality of second metal strips arranged side by side, wherein the first metal strips and the second metal strips are arranged alternately in sequence.
optionally, wherein the first chip comprises a logic chip and the second chip comprises a memory chip, or the first chip and the second chip are both logic chips.
optionally, wherein the first element comprises at least one of an inductor, a sensor or a capacitor.

11. A packaging method for forming the packaging structure according to any one of claims 1-10, comprising:
providing a first chip having a first element;
providing a second chip having a shielding element; and
stacking the first chip and the second chip, wherein the shielding element is arranged on one side of the second chip close to the first chip, an active surface of the second chip is arranged opposite to an active surface of the first chip, and the shielding element is configured to reduce signal interference from the second chip to the first element.

12. The method of claim 11, wherein providing the first chip having the first element, comprises:
forming one or more first wiring layers on the active surface of the first chip, wherein the first wiring layers are arranged along a thickness direction of the packaging structure; and
forming the first element via at least one of the first wiring layers.
optionally, at least one of the first wiring layers being a first top layer, wherein the first top later is arranged closer to the second chip than other first wiring layers in the thickness direction of the packaging structure, and the first element is at least partially arranged on the first top layer.

13. The method of claim 11, wherein providing the second chip having the shielding element, comprises:
forming one or more second wiring layers on the active surface of the second chip, wherein the second wiring layers are arranged along a thickness direction of the packaging structure; and
forming the shielding element via at least one of the second wiring layers.
optionally, at least one of the second wiring layers being a second top layer, wherein the second top layer is arranged closer to the first chip than other second wiring layers in the thickness direction of the packaging structure, and the shielding element is arranged on the second top layer.

14. A chip stacking structure, comprising:
a substrate; and
a packaging structure arranged on the substrate, wherein the packaging structure is the packaging structure according to any one of claims 1-10.

15. An electronic device, comprising:
a printed circuit board; and
a packaging structure, wherein the packaging structure is the packaging structure according to any one of claims 1-10, and the printed circuit board is connected with the packaging structure.
